# EUROPÄISCHE PATENTSCHRIFT

(11) **EP 3 368 380 B1**
(45) Veröffentlichungstag und Bekanntmachung des Hinweises auf die Patenterteilung: **17.07.2019**
(21) Anmeldenummer: 16781363.3
(22) Anmeldetag: 10.10.2016
(51) Int. Cl.: B60R 16/027

(54) **SCHUTZABDECKUNG FÜR EIN WICKELFEDERGEHÄUSE, WICKELFEDERGEHÄUSEANORDNUNG UND FAHRZEUG MIT EINER SOLCHEN WICKELFEDERGEHÄUSEANORDNUNG**
PROTECTION FOR A SPIRAL CABLE HOUSING, SPIRAL CABLE ASSEMBLY AND VEHICLE WITH SUCH AN ASSEMBLY
PROTECTION POUR CASSETTE DE CÂBLE SPIRAL, ENSEMBLE DE CASSETTE DE CÂBLE SPIRAL ET VÉHICULE AVEC UN TEL ENSEMBLE

(30) Priorität: 29.10.2015 DE 102015118543
(43) Veröffentlichungstag der Anmeldung: 05.09.2018
(73) Patentinhaber: Valeo Schalter und Sensoren GmbH, 74321 Bietigheim-Bissingen (DE)
(72) Erfinder: SIMONIS, Karl, 74321 Bietigheim-Bissingen (DE); JAECKLE, Daniela, 74321 Bietigheim-Bissingen (DE); RADDAZ, Laurent, 74321 Bietigheim-Bissingen (DE); HERTL, Uwe, 74321 Bietigheim-Bissingen (DE)
(86) Internationale Anmeldenummer: PCT/EP2016/074177
(87) Internationale Veröffentlichungsnummer: WO 2017/071939

(56) Entgegenhaltungen:
- EP-A1- 0 646 497
- DE-A1- 4 027 952
- US-A- 4 475 779
- US-A- 5 137 463
- US-A- 5 429 517

## Beschreibung

Die Erfindung betrifft eine Schutzabdeckung zur Abdichtung eines Wickelfedergehäuses, wobei das Wickelfedergehäuse ein erstes Gehäuseteil sowie wenigstens ein zweites, einen Gehäusedeckel bildendes Gehäuseteil aufweist. Das erste Gehäuseteil bildet dabei mit dem zweiten Gehäuseteil einen Aufnahmeraum für eine Wickelfeder, wobei die beiden Gehäuseteile gegeneinander drehbar sind. Dazu weist das Wickelfedergehäuse zwischen dem ersten Gehäuseteil und dem zweiten Gehäuseteil einen Spalt auf.

Ferner betrifft die Erfindung eine Wickelfedergehäuseanordnung mit einem vorbeschriebenen Wickelfedergehäuse und einer Schutzabdeckung sowie ein Fahrzeug, insbesondere ein zweispuriges Fahrzeug, mit einer Wickelfedergehäuseanordnung, die ein vorbeschriebenes Wickelfedergehäuse und eine vorbeschriebene Schutzabdeckung aufweist.

Wickelfedergehäuse zur Aufnahme einer Wickelfeder sind aus dem Stand der Technik grundsätzlich bekannt, wobei Wickelfedern spiralförmig aufgewickelte Kabel sind, insbesondere Flachbandkabel, die mehrere elektrische Leiter aufweisen, welche elektrisch voneinander isoliert sind. Durch die spiralförmige Aufwicklung, die eine federnde, flexible und damit ausgleichende Kabelverbindung ermöglicht, eignen sich Wickelfedern insbesondere zur Übertragung von Signalen, wie beispielsweise elektrischer Spannung und/oder dergleichen zwischen relativ zueinander bewegbaren Komponenten, wie beispielsweise einem Lenkrad und einem Lenkstockmodul.

Wickelfedern werden vor allem in Kraftfahrzeugen eingesetzt, insbesondere zur Signalübertragung zwischen im drehbeweglichen Lenkrad integrierten Komponenten, wie beispielsweise einem Airbag oder einer Lenkradheizung, an zugehörige, ortsfest im Fahrzeug angeordnete Komponenten, wie beispielsweise einem zugehörigen Airbag-Steuergerät.

Dabei sind die Wickelfedern üblicherweise im Lenkrad oder im Lenkstockhebelgehäuse aufgenommen, wobei die Wickelfedern dazu direkt im Lenkrad oder dem Lenkstockhebelgehäuse angeordnet sind oder aber in einem separaten Wickelfedergehäuse, das in das Lenkrad oder den Lenkstockhebel eingesetzt werden kann.

Aus dem Stand der Technik sind vielfältige Ausgestaltungen von Wickelfedergehäusen bekannt, beispielsweise aus der US 5,137,463, der US 5,314,344, der US 6,962,497 B2 oder der DE 101 25 403 A1.

Üblicherweise weist ein Wickelfedergehäuse ein erstes Gehäuseteil sowie wenigstens ein zweites, einen Gehäusedeckel bildendes Gehäuseteil auf, wobei die beiden Gehäuseteile gegeneinander drehbar sind und einen Aufnahmeraum für eine Wickelfeder bilden. Dabei bildet eines der Gehäuseteile einen sogenannten Stator und kann in einem Fahrzeug ortsfest gegenüber dem Fahrzeugaufbau befestigt werden, beispielsweise an einem Lenkstockmodul oder dergleichen, während das andere Gehäuseteil einen Rotor bildet und drehfest am Lenkrad oder einer Lenksäule befestigt werden kann, so dass das dieses Gehäuseteil einer Drehbewegung des Lenkrads folgen kann und gegenüber dem ortsfesten Gehäuseteil verdreht werden kann.

Um eine gute Drehbeweglichkeit der beiden Gehäuseteile zueinander zu erreichen, ist in der Regel ein Spalt, wenn auch oft nur sehr kleiner Spalt, zwischen dem ersten Gehäuseteil und dem zweiten Gehäuseteil vorhanden. Um ein Eindringen von Fremdkörpern in das Wickelfedergehäuse zu vermeiden, sind verschiedene Möglichkeiten bekannt, wie beispielsweise eine spezielle Wickelfedergehäusegestaltung, Dichtungseinrichtungen einzusetzen oder Schutzabdeckungen zu verwenden.

Aufgabe der vorliegenden Erfindung ist es eine alternative, insbesondere eine besonders einfach aufgebaute, aber äußert wirkungsvolle Schutzabdeckung zur Abdichtung eines Wickelfedergehäuses bereitzustellen, mit der insbesondere zuverlässig das Eindringen von Fremdkörpern ins Innere eines Wickelfedergehäuses vermieden werden kann. Ferner ist es Aufgabe der Erfindung eine entsprechende Wickelfedergehäuseanordnung mit einem Wickelfedergehäuse und einer Schutzabdeckung sowie ein entsprechendes Fahrzeug mit einer Wickelfedergehäuseanordnung bereitzustellen.

Diese Aufgabe wird erfindungsgemäß durch eine Schutzabdeckung, durch eine Wickelfedergehäuseanordnung sowie durch ein Fahrzeug mit den Merkmalen gemäß den jeweiligen unabhängigen Patentansprüchen gelöst. Vorteilhafte Ausführungen der Erfindung sind Gegenstand der abhängigen Patentansprüche, der Beschreibung und der Figuren und werden im Folgenden näher erläutert. Der Wortlaut der Ansprüche wird durch ausdrückliche Bezugnahme zum Inhalt der Beschreibung gemacht. Manche der nachfolgenden, genannten Merkmale werden, um Wiederholungen zu vermeiden, teilweise nur einmal beschrieben, das heißt nur im Zusammenhang mit der Schutzabdeckung, der Wickelfedergehäuseanordnung oder dem Fahrzeug, gelten jedoch unabhängig voneinander sowohl für die Schutzabdeckung als auch für die Wickelfedergehäuseanordnung sowie für das Fahrzeug.

Eine erfindungsgemäße Schutzabdeckung für ein Wickelfedergehäuse ist dadurch gekennzeichnet, dass die Schutzabdeckung eine sich in radialer Richtung zumindest über einen Teil eines Umfangs erstreckende Ringscheibe und einen sich an einem äußeren Rand der Ringscheibe anschließenden und zumindest über einen Teil des Umfangs in axialer Richtung erstreckenden Wandabschnitt aufweist, wobei die Schutzabdeckung derart mit dem Wickelfedergehäuse verbindbar ist, dass in einem funktionsgemäßen, mit dem Wickelfedergehäuse zu einer Wickelfedergehäuseanordnung verbundenen Zustand, die Schutzabdeckung den Spalt zwischen dem zweiten Gehäuseteil und dem ersten Gehäuseteil des Wickelfedergehäuses von außen abdeckt.

Die verwendeten Lage- und Richtungsbezeichnungen "oben", "unten", "radial" und "axial" sind im Sinne dieser Anmeldung dabei jeweils auf die Drehachse bezogen, um welche eine der beiden Gehäuseteile des Wickelfedergehäuses in einem funktionsgemäßen Einbauzustand in einem Fahrzeug drehbar ist, wobei die Lagebezeichnung "oben" eine dem Lenkrad eines Fahrzeugs zugewandte Seite bezeichnet, die Lagebezeichnung "unten", eine dem Lenkstockmodul zugewandte Seite, die Angabe "axial" entlang einer Achse parallel zur Drehachse bzw. entlang der Drehachse meint und "radial" entsprechend in einer Ebene senkrecht zur Drehachse die Drehachse schneidend.

In radialer Richtung meint im Sinne dieser Anmeldung somit in einer Ebene senkrecht zur Drehachse einer Lenksäule bzw. eines Lenkrads, bezogen auf einen funktionsgemäßen Einbauzustand in einem Fahrzeug, die Drehachse schneidend.

In axialer Richtung meint im Sinne dieser Anmeldung entsprechend entlang einer Achse parallel zur Drehachse der Lenksäule bzw. des Lenkrads oder mit der Drehachse des Lenkrads bzw. der Lenksäule zusammenfallend, bezogen auf einen funktionsgemäßen Einbauzustand einer erfindungsgemäßen Schutzabdeckung bzw. einer erfindungsgemäßen Wickelfedergehäuseanordnung in einem Fahrzeug.

Unter einem Spalt wird im Sinne dieser Anmeldung jede nicht-dichte Anordnung zweier Teile zueinander verstanden, insbesondere jede nicht-dichte Anordnung gegenüber Fremdkörpern.

Bevorzugt erstreckt sich die Ringscheibe der Schutzabdeckung dabei über den gesamten Umfang, das heißt über einen Winkel von 360° und bildet eine vollständig geschlossene Ringscheibe. Der axiale Wandabschnitt der Schutzabdeckung ist ebenfalls vorzugsweise vollständig umlaufend ausgebildet und damit zylindermantelförmig ausgebildet.

Mit einer erfindungsgemäßen Schutzabdeckung, insbesondere mit einer Schutzabdeckung, die eine vollständig umlaufend ausgebildete Ringscheibe aufweist und vorzugsweise einen ebenfalls vollständig umlaufend ausgebildeten Wandabschnitt, kann auf einfache Art und Weise eine Schutzabdeckung bereitgestellt werden, die äußerst wirkungsvoll den Spalt zwischen dem ersten Gehäuseteil und dem zweiten Gehäuseteil eines Wickelfedergehäuses gegen das Eindringen von Fremdkörpern abdichtet.

Eine erfindungsgemäße Schutzabdeckung eignet sich besonders für ein Wickelfedergehäuse, das einen ersten, topfförmigen Gehäuseteil mit einem ringscheibenförmig ausgestalteten Boden und mit einem zylindermantelförmigen Wandabschnitt aufweist sowie wenigstens einen zweiten, einen Gehäusedeckel bildenden Gehäuseteil mit wenigstens einem ringförmigen Abschnitt, der sich in radialer Richtung erstreckt und in axialer Richtung beabstandet zum ringscheibenförmigen Boden des ersten Gehäuseteils angeordnet ist und mit dem ersten Gehäuseteil den Aufnahmeraum für die Wickelfeder bildet, wobei dazu der ringscheibenförmige Abschnitt des zweiten Gehäuseteils bevorzugt beabstandet zum ringscheibenförmig ausgestalteten Boden des ersten Gehäuseteils angeordnet ist, besonders bevorzugt parallel zum Boden des ersten Gehäuseteils.

Vorzugsweise ist dabei der topfförmige, erste Gehäuseteil des Wickelfedergehäuses als Stator vorgesehen und dazu ausgebildet, ortsfest am Fahrzeugaufbau angeordnet zu werden und beispielsweise in einem Lenkstockmodul oder dergleichen befestigt zu werden, während der zweite Gehäuseteil bevorzugt dazu vorgesehen ist einen Rotor zu bilden und insbesondere dazu ausgebildet ist, an der Lenksäule und/oder am Lenkrad befestigt zu werden.

Eine erfindungsgemäße Schutzabdeckung eignet sich dabei zum Abdichten verschieden ausgestalteter Wickelfedergehäuse, insbesondere unter anderem für die folgenden, drei, grundsätzlichen Arten von Wickelfedergehäusen, die sich vor allem in der Ausgestaltung des ersten und zweiten Gehäuseteils sowie in der Anordnung des ersten und zweiten Gehäuseteils zueinander unterscheiden.

Bei der ersten Art von Wickelfedergehäusen, wie sie beispielsweise aus der DE 101 25 403 A1 bekannt sind, erstreckt sich der ringscheibenförmige Abschnitt des zweiten Gehäuseteils fast bis an den zylinderförmigen Wandabschnitt des ersten Gehäuseteils heran, so dass ein Wickelfedergehäuse dieser Art einen Spalt zwischen einem äußeren Rand des ringförmigen Abschnitts des zweiten Gehäuseteils und dem zylinderförmigen Wandabschnitt des ersten Gehäuseteils aufweist.

Bei der zweiten Art von Wickelfedergehäusen weist der erste Gehäuseteil im oberen Bereich des zylinderförmigen Wandabschnitts, das heißt an einem vom Boden des ersten Gehäuseteils abgewandten Ende des zylindermantelförmigen Wandabschnittes, einen sich radial nach innen erstreckenden Flansch bzw. Ringabschnitt auf, welcher sich vorzugsweise in einer parallelen Ebene zum ringförmigen Abschnitt des zweiten Gehäuseteils erstreckt und insbesondere labyrinthmäßig mit diesem überlappt. Bei Wickelfedergehäusen dieser Art befindet sich der Spalt dabei zwischen den beiden ringscheibenförmigen, sich in radialer Richtung erstreckenden Abschnitten des ersten Gehäuseteils und des zweiten Gehäuseteils.

Dabei kann das erste Gehäuseteil auch mehrteilig ausgebildet sein und beispielsweise aus einen topfförmigen Gehäuseteil und einem ebenfalls topfförmigen Deckel zusammengesetzt sein, wobei der topfförmige Deckel einen zylindermantelförmigen axialen Wandabschnitt und eine sich in radialer Richtung an einem oberen Rand des zylindermantelförmigen Wandabschnitts anschließende Ringscheibe aufweist, welche einen sich nach innen erstreckenden Ringabschnitt bildet, wobei der Deckel fest mit dem topfförmigen Gehäuseteil verbunden ist und der zylindermantelförmige axiale Wandabschnitt des Deckels zumindest teilweise am axialen Wandabschnitt des topfförmigen Gehäuseteils anliegt. In diesem Fall befindet sich der Spalt dabei zwischen dem sich nach innen erstreckenden Ringabschnitt des mit dem topfförmigen Gehäuseteil verbundenen Deckels und dem in radialer Richtung erstreckenden Abschnitt des zweiten Gehäuseteils.

Des Weiteren ist noch eine dritte Art von Wickelfedergehäusen bekannt, wobei bei diesen Wickelfedergehäusen das zweite Gehäuseteil einen ringförmigen Abschnitt aufweist, an dessen äußeren Ende sich ein zylindermantelförmiger Wandabschnitt anschließt, der sich in Richtung Boden des ersten Gehäuseteils erstreckt, vorzugsweise außerhalb des ersten, topfförmigen Gehäuseteils. Das heißt mit anderen Worten, bei dieser dritten Art von Wickelfedergehäusen ist das zweite Gehäuseteil ebenfalls topfförmig ausgebildet und mit einem Boden nach oben angeordnet, das heißt mit dem Boden in Richtung des Lenkrads, bezogen auf einen funktionsgemäßen Einbauzustand des Wickelfedergehäuses in einem Fahrzeug. Dabei erstreckt sich der zylindermantelförmige Wandabschnitt bzw. der sich in axialer Richtung erstreckende Wandabschnitt des zweiten Gehäuseteils bevorzugt parallel zum zylindermantelförmigen Wandabschnitt des ersten Gehäuseteils und ist insbesondere außerhalb von diesem angeordnet. Der Spalt zwischen dem ersten Gehäuseteil und dem zweiten Gehäuseteil befindet sich somit folglich im Bereich der zylindermantelförmigen Wandabschnitte.

Zur Abdichtung von Wickelfedergehäusen der ersten und/oder zweiten Art ist eine erfindungsgemäße Schutzabdeckung in einer vorteilhaften Ausgestaltung derart ausgebildet und kann derart mit dem Wickelfedergehäuse verbunden werden, dass die Ringscheibe der Schutzabdeckung den Spalt von außen abdeckt, wobei sich die Ringscheibe der Schutzabdeckung vorzugsweise in radialer Richtung über eine Spaltbreite hinaus erstreckt. Dabei liegt die Ringscheibe vorzugsweise am sich in radialer Richtung erstreckenden ersten Gehäuseteil und am zweiten Gehäuseteil an, insbesondere auf.

Zur Abdichtung von Wickelfedergehäusen der dritten Art mit einem Spalt im Bereich des zylindermantelförmigen Wandabschnitts des ersten Gehäuseteils bzw. des zweiten Gehäuseteils ist eine erfindungsgemäße Schutzabdeckung in einer vorteilhaften Ausgestaltung derart ausgebildet und kann derart mit dem Wickelfedergehäuse verbunden werden, dass in einem mit dem Wickelfedergehäuse zu einer Wickelfedergehäuseanordnung verbundenen Zustand der axiale Wandabschnitt der Schutzabdeckung den Spalt des Wickelfedergehäuses von außen abdeckt, wobei sich der axiale Wandabschnitt der Schutzabdeckung dazu vorzugsweise in axialer Richtung über eine Spalthöhe hinaus erstreckt.

In einer besonders vorteilhaften Ausgestaltung einer erfindungsgemäßen Schutzabdeckung ist die Schutzabdeckung derart ausgebildet, dass in einem mit dem Wickelfedergehäuse zu einer Wickelfedergehäuseanordnung verbundenen Zustand der axiale Wandabschnitt der Schutzabdeckung in radialer Richtung am ersten Gehäuseteil anliegt, zumindest über einen Teil des Umfangs, vorzugsweise vollständig umlaufend, und dadurch in radialer Richtung gegenüber dem Wickelfedergehäuse festgelegt ist. Auf diese Weise kann eine radiale Fixierung der Schutzabdeckung gegenüber dem Wickelfedergehäuse besonders einfach und kostengünstig realisiert werden, wobei die Schutzabdeckung bevorzugt im Bereich des zylindermantelförmigen Wandabschnittes des ersten Gehäuseteils außen am Wickelfedergehäuse anliegt.

In einer weiteren vorteilhaften Ausgestaltung einer erfindungsgemäßen Schutzabdeckung weist die Schutzabdeckung zur axialen Festlegung gegenüber dem Wickelfedergehäuse an ihrem axialen Wandabschnitt in Umfangsrichtung verteilt, vorzugsweise gleichmäßig verteilt, mehrere Rastelemente auf, insbesondere elastisch federnde Rasthaken, zum Herstellen einer Rastverbindung mit dem Wickelfedergehäuse, insbesondere mit dem ersten Gehäuseteil des Wickelfedergehäuses. Die Rastelemente der Schutzabdeckung sind dabei vorzugsweise derart ausgebildet, dass sie hinter jeweils einem korrespondierend ausgebildeten Vorsprung am Wickelfedergehäuse verrasten, insbesondere hinter jeweils korrespondierend ausgebildeten Vorsprüngen am zylindermantelförmigen Wandabschnitt des ersten Gehäuseteils des Wickelfedergehäuses. Besonders bevorzugt sind die Rastelemente der Schutzabdeckung dabei als Rastnasen oder Rasthaken ausgebildet, welche unter einen sich in radialer Richtung erstreckenden, am ersten Gehäuseteil angeordneten Vorsprung greifen und dadurch mit dem Wickelfedergehäuse rastverbunden werden können.

In einer weiteren vorteilhaften Ausgestaltung einer erfindungsgemäßen Schutzabdeckung ist die Schutzabdeckung aus wenigstens zwei Ringsegmenten gebildet, vorzugsweise aus zwei Halbringsegmenten. Das heißt, vorzugsweise ist die Schutzabdeckung aus zwei Ringhälften gebildet, die sich jeweils über einen Umfangswinkel von 180° erstrecken. Die Aufteilung der Schutzabdeckung in wenigstens zwei separate Ringsegmente, insbesondere zwei Halbringsegmente, ermöglicht eine radiale Anordnung bzw. Montage der Schutzabdeckung von außen um das Wickelfedergehäuse herum, so dass keine axiale Montage bzw. ein axiales Aufschieben der Schutzabdeckung auf das Wickelfedergehäuse erforderlich ist. Dadurch kann die Schutzabdeckung auch nachträglich mit dem Wickelfedergehäuse verbunden werden, das heißt auch nach dem Einbau des Wickelfedergehäuses in ein Fahrzeug, insbesondere ohne dass das Lenkrad demontiert werden muss.

In einer weiteren vorteilhaften Ausgestaltung einer erfindungsgemäßen Schutzabdeckung sind zwei erste, benachbarte Ringsegmentenden mittels eines Scharniers miteinander verbunden, vorzugsweise mittels eines Filmscharniers. Dabei sind insbesondere nur die axialen Wandabschnitte der Ringsegmentenden mittels des Scharniers miteinander verbunden und nicht die Ringsegmentenden der Ringscheibe.

In einer weiteren vorteilhaften Ausgestaltung einer erfindungsgemäßen Schutzabdeckung sind zwei andere, benachbarte Ringsegmentenden mittels einer Rastverbindung miteinander verbindbar oder miteinander verbunden.

Ist die Schutzabdeckung durch zwei Ringsegmente gebildet, insbesondere durch zwei Halbringsegmente, sind bevorzugt die beiden Halbringsegmente an zwei ersten, benachbarten Ringsegmentenden mittels eines Scharniers verbunden, insbesondere mittels eines Filmscharniers, und an den anderen beiden, zweiten Ringsegmentenden mittels einer Rastverbindung bzw. sie können bevorzugt an den anderen beiden Ringsegmentenden mittels einer Rastverbindung miteinander verbunden werden. Eine derartig ausgestaltete Schutzabdeckung lässt sich besonders einfach mit einem, bereits in einem Fahrzeug eingebauten Wickelfedergehäuse verbinden, da die Schutzabdeckung entsprechend aufgeklappt und von außen um das Wickelfedergehäuse herumgelegt werden kann und lediglich die beiden zweiten Ringsegmentenden mittels der Rastverbindung verbunden werden müssen, um die Schutzabdeckung um das Wickelfedergehäuse radial zu fixieren. Für eine axiale Fixierung sind zusätzlich lediglich, sofern vorhanden die Rastelemente an den axialen Wandabschnitten der Schutzabdeckung mit den entsprechenden Vorsprüngen am Wickelfedergehäuse in Eingriff zu bringen und entsprechend zu verrasten.

In einer weiteren vorteilhaften Ausgestaltung einer erfindungsgemäßen Schutzabdeckung weist die Ringscheibe der Schutzabdeckung auf einer, in einem funktionsgemäßen Einbauzustand in einem Fahrzeug, dem als Rotor ausgebildeten Gehäuseteil zugewandten Seite und/oder einer dem Lenkrad zugewandten Seite, eine Oberfläche mit einer geringen Rauigkeit auf, insbesondere eine Oberfläche mit einem geringen Reibwert. Dadurch kann eine auftretende Reibung zwischen dem als Rotor ausgebildeten Gehäuseteil und/oder dem Lenkrad und/oder anderen Komponenten und der Schutzabdeckung reduziert werden.

In einer weiteren vorteilhaften Ausgestaltung einer erfindungsgemäßen Schutzabdeckung weist in einem funktionsgemäßen Einbaustand der Schutzabdeckung in einem Fahrzeug wenigstens die dem als Rotor ausgebildeten Gehäuseteil zugewandte Seite und/oder die dem Lenkrad zugewandte Seite der Ringscheibe der Schutzabdeckung eine antistatische Oberfläche auf. Vorzugsweise weist jedoch die gesamte Schutzabdeckung eine antistatische Oberfläche auf, insbesondere ist die gesamte Schutzabdeckung antistatisch ausgebildet. Dadurch kann eine elektrische Aufladung der Schutzabdeckung verringert bzw. vermieden werden.

Eine erfindungsgemäße Wickelfedergehäuseanordnung weist ein Wickelfedergehäuse und eine erfindungsgemäße, vorbeschriebene Schutzabdeckung auf, wobei das Wickelfedergehäuse ein erstes Gehäuseteil sowie wenigstens ein zweites, einen Gehäusedeckel bildendes Gehäuseteil aufweist, wobei das erste Gehäuseteil mit dem zweiten Gehäuseteil einen Aufnahmeraum für eine Wickelfeder bildet, wobei die beiden Gehäuseteile gegeneinander drehbar sind und wobei das Wickelfedergehäuse zwischen dem ersten Gehäuseteil und dem zweiten Gehäuseteil einen Spalt aufweist, der durch die Schutzabdeckung von außen abgedeckt ist. Die Schutzabdeckung dichtet dabei vorzugsweise den Spalt ab, insbesondere gegen ein Eindringen von Fremdkörpern.

In einer weiteren vorteilhaften Ausgestaltung einer erfindungsgemäßen Wickelfedergehäuseanordnung weist das Wickelfedergehäuse ein erstes, topfförmiges Gehäuseteil mit einem ringscheibenförmig ausgestalteten Boden und mit einem zylindermantelförmigen Wandabschnitt auf sowie wenigstens ein zweites, einen Gehäusedeckel bildendes Gehäuseteil mit wenigstens einem ringscheibenförmigen Abschnitt, wobei sich der ringförmige Abschnitt des zweiten Gehäuseteils in radialer Richtung erstreckt und in axialer Richtung beabstandet zum ringscheibenförmigen Boden des ersten Gehäuseteils angeordnet ist und mit dem ersten Gehäuseteil den Aufnahmeraum für eine Wickelfeder bildet und wobei sich der Spalt zwischen dem ersten Gehäuseteil und dem zweiten Gehäuseteil befindet.

In einer bevorzugten, vorteilhaften Ausgestaltung einer erfindungsgemäßen Wickelfedergehäuseanordnung deckt die Ringscheibe der Schutzabdeckung den Spalt im Wickelfedergehäuse von außen ab, wobei sich die Ringscheibe der Schutzabdeckung dazu vorzugsweise in radialer Richtung über eine Spaltbreite hinaus erstreckt und insbesondere vollständig umlaufend ausgebildet ist.

Besonders bevorzugt liegt die Ringscheibe dabei auf dem ringscheibenförmigen Abschnitt des zweiten Gehäuseteils an bzw. auf. Ist der erste Gehäuseteil mehrteilig ausgebildet und weist einen entsprechenden, sich nach innen in radialer Richtung erstreckenden Flansch bzw. ringscheibenförmigen Abschnitt auf, kann die Ringscheibe der Schutzabdeckung auch auf diesem aufliegen.

In einer weiteren vorteilhaften, alternativen oder zusätzlichen Ausgestaltung einer erfindungsgemäßen Wickelfedergehäuseanordnung deckt der axiale Wandabschnitt der Schutzabdeckung den Spalt von außen ab, wobei dieser sich dazu vorzugsweise in axialer Richtung über eine Spalthöhe hinaus erstreckt und insbesondere vollständig umlaufend ausgebildet ist.

In einer weiteren vorteilhaften Ausgestaltung einer erfindungsgemäßen Wickelfedergehäuseanordnung liegt der axiale Wandabschnitt der Schutzabdeckung in radialer Richtung außen am Wickelfedergehäuse an, vorzugsweise am ersten Gehäuseteil, insbesondere vollständig umlaufend, und ist dadurch in radialer Richtung gegenüber dem Wickelfedergehäuse festgelegt.

In einer weiteren vorteilhaften Ausgestaltung einer erfindungsgemäßen Wickelfedergehäuseanordnung ist die Schutzabdeckung zur axialen Festlegung gegenüber dem Wickelfedergehäuse mit dem Wickelfedergehäuse mittels mehrerer, vorzugsweise in Umfangsrichtung gleichmäßig verteilt angeordneten Rastverbindungen verbunden. Vorzugsweise weist die Schutzabdeckung dazu, insbesondere an ihrem axialen Wandabschnitt in Umfangsrichtung verteilt, insbesondere gleichmäßig verteilt, mehrere Rastelemente auf, vorzugsweise elastisch federnde Rasthaken. Das Wickelfedergehäuse weist vorzugsweise mehrere, korrespondierend ausgebildete Rastvorsprünge auf, wobei diese besonders bevorzugt am zylindermantelförmigen Wandabschnitt des ersten Gehäuseteils angeordnet sind. Bevorzugt greifen die Rasthaken der Schutzabdeckung dabei hinter bzw. unter die Rastvorsprünge am Wickelfedergehäuse und bilden so entsprechende Rastverbindungen, so dass die Schutzabdeckung am Wickelfedergehäuse in axialer Richtung festgelegt ist und mit diesem verbunden ist.

Ein erfindungsgemäßes Fahrzeug, insbesondere ein erfindungsgemäßes zweispuriges Fahrzeug, mit einer Wickelfedergehäuseanordnung mit einem Wickelfedergehäuse und einer Schutzabdeckung weist eine erfindungsgemäße Wickelfedergehäuseanordnung und eine erfindungsgemäße Schutzabdeckung auf.

Bevorzugt ist der erste Gehäuseteil einer erfindungsgemäßen Schutzabdeckung dabei als Stator ausgebildet und stationär am Fahrzeug befestigt, insbesondere an einem Längsstockhebelgehäuse oder dergleichen. Der zweite Gehäuseteil des Wickelfedergehäuses ist vorzugsweise als Rotor ausgebildet und an der Lenksäule und/oder dem Lenkrad befestigt.

Die mit dem Wickelfedergehäuse zu einer Wickelfedergehäuseanordnung verbundene, erfindungsgemäße Schutzabdeckung ist dabei, insbesondere im Bereich ihres axialen Wandabschnittes, bevorzugt zumindest teilweise von einer Verkleidung derart umgeben, dass die Schutzabdeckung durch die Verkleidung in radialer Richtung zusätzlich festgelegt ist. Das heißt mit anderen Worten, dass die Schutzabdeckung bei einem erfindungsgemäßen Fahrzeug bevorzugt mit ihrem axialen Wandabschnitt, insbesondere mit dessen Innenseite, am zylindermantelförmigen Wandabschnitt des topfförmigen ersten Gehäuseteils anliegt und zum anderen, insbesondere mit einer Außenseite ihres axialen Wandabschnittes, zumindest teilweise an der Verkleidung. Auf diese Weise kann sehr einfach eine zusätzliche radiale Fixierung bzw. Festlegung der Schutzabdeckung in radialer Richtung am Fahrzeug erreicht werden.

Die mit Bezug auf die Schutzabdeckung vorgestellten vorteilhaften Ausgestaltungen und deren Vorteile gelten entsprechend auch für die erfindungsgemäße Wickelfedergehäuseanordnung sowie für ein erfindungsgemäßes Kraftfahrzeug.

Weitere Merkmale der Erfindung ergeben sich aus den Ansprüchen, den Figuren und der Figurenbeschreibung. Alle vorstehend in der Beschreibung genannten Merkmale und Merkmalskombinationen sowie die nachfolgenden, in der Figurenbeschreibung genannten und/oder in den Figuren alleine gezeigten Merkmale und Merkmalskombinationen sind nicht nur in der jeweils angegebenen Kombination, sondern auch in anderen Kombinationen oder aber in Alleinstellung verwendbar.

Die Erfindung wird nun anhand eines bevorzugten Ausführungsbeispiels unter Bezugnahme auf die beigefügten Zeichnungen näher erläutert.

Es zeigen:
- Fig. 1: einen Schnitt durch ein Ausführungsbeispiel einer erfindungsgemäßen, in einem Fahrzeug angeordneten Wickelfedergehäuseanordnung,
- Fig. 2: einen Ausschnitt der erfindungsgemäßen Wickelfedergehäuseanordnung aus Fig. 1 in vergrößerter Darstellung,
- Fig. 3A: die erfindungsgemäße Schutzabdeckung aus den Fig. 1 und 2 in perspektivischer Einzelteildarstellung in einem funktionsgemäßen Verwendungszustand und
- Fig. 3B: die erfindungsgemäße Schutzabdeckung aus Fig. 3A in einem Montagezustand.

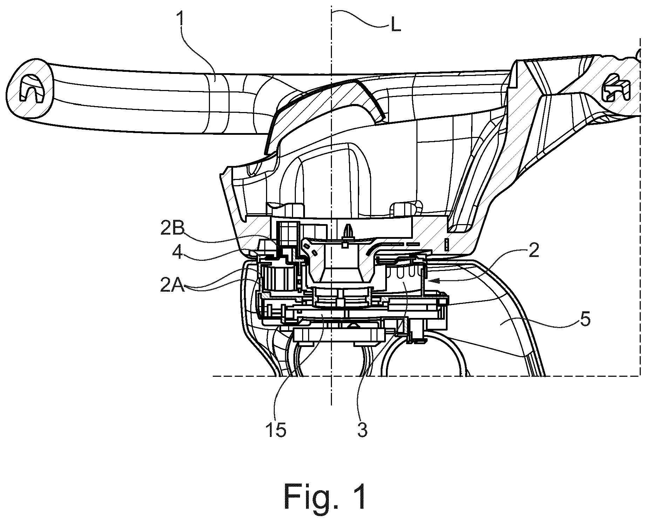

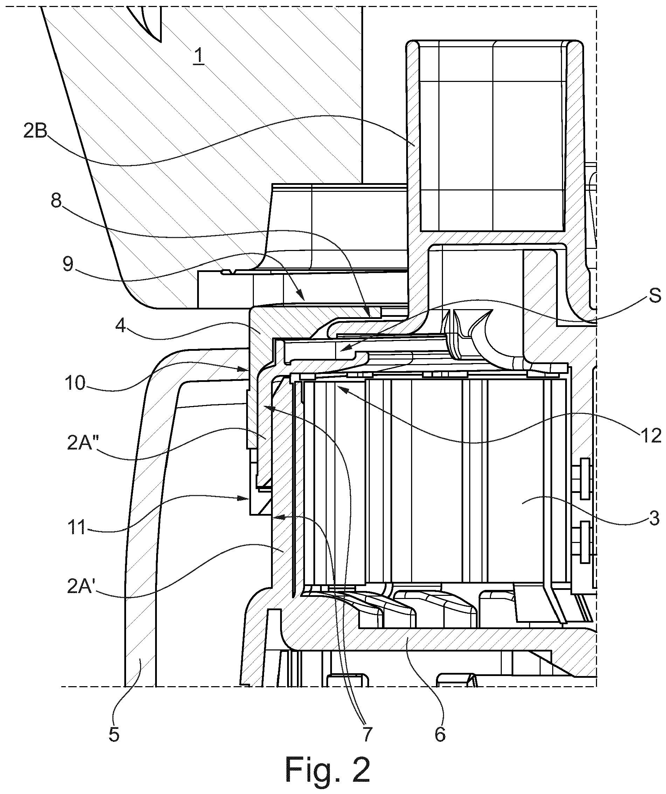

Fig. 1 zeigt ein Ausführungsbeispiel einer erfindungsgemäßen Wickelfedergehäuseanordnung mit einem Wickelfedergehäuse 2 aus Kunststoff sowie einer erfindungsgemäßen Schutzabdeckung 4, die ebenfalls aus Kunststoff hergestellt ist, in einem funktionsgemäßen Einbauzustand in einem Fahrzeug zwischen einem Lenkrad 1 und einem, von einer Verkleidung 5 umgebenen Lenkstockmodul 15. Fig. 2 zeigt zum besseren Verständnis einen Ausschnitt der erfindungsgemäßen Wickelfedergehäuseanordnung aus Fig. 1 in vergrößerter Darstellung.

Das Wickelfedergehäuse 2 besteht dabei aus einem ersten, topfförmigen Gehäuseteil 2A mit einem ringscheibenförmig ausgestalteten Boden 6 und mit einem zylindermantelförmigen Wandabschnitt 7 sowie einem zweiten, einen Gehäusedeckel bildenden Gehäuseteil 2B. Innerhalb des Wickelfedergehäuses 2 ist in einem durch das erste Gehäuseteil 2A und das zweite Gehäuseteil 2B gebildeten Aufnahmeraum eine Wickelfeder 3 angeordnet. Der Aufnahmeraum für die Wickelfeder 3 wird dabei an einer Unterseite durch den ringscheibenförmig ausgestalteten Boden 6 des ersten Gehäuseteils 2A gebildet, sowie durch den zylindermantelförmigen Wandabschnitt 7 des ersten Gehäuseteils 2A und durch den ringscheibenförmigen Abschnitt 8 des zweiten Gehäuseteils 2B, welcher einen Gehäusedeckel bildet.

Bei diesem Ausführungsbeispiel einer erfindungsgemäßen Wickelfedergehäuseanordnung ist das erste Gehäuseteil 2A mehrteilig ausgebildet, siehe Fig. 2, und insbesondere aus einem ersten topfförmig ausgestalteten Gehäuseteil 2A' sowie einem zweiten, ebenfalls topfförmig ausgestalteten Gehäuseteil 2A" zusammengesetzt, wobei der zweite topfförmig ausgestaltete Gehäuseteil 2A" einen sich in radialer Richtung nach innen erstreckenden, ringscheibenförmigen Abschnitt 12 aufweist, welcher sich nach Art einer Labyrinthdichtung zwischen dem ringscheibenförmigen Abschnitt 8 des zweiten Gehäuseteils 2B sowie dem zylindermantelförmigen Wandabschnitt 7 des ersten Gehäuseteils 2A ins Innere des Wickelfedergehäuse 2 hineinerstreckt.

Das erste Gehäuseteil 2A ist als Stator ausgebildet und über das Lenkstockmodul 15 stationär bzw. ortsfest am Fahrzeugaufbau befestigt, während das zweite Gehäuseteil 2B als Rotor wirkt und drehfest mit einer hier nicht dargestellten Lenksäule verbunden ist, welche um eine Drehachse L drehbar ist, zusammen mit dem ebenfalls drehfest an der Lenksäule befestigten Lenkrad 1. Das heißt, der erste Gehäuseteil 2A und der zweite Gehäuseteil 2B drehen bei jeder Lenkbewegung gegeneinander.

Damit das zweite Gehäuseteil 2B gegenüber dem ersten Gehäuseteil 2A möglichst reibungsfrei drehbar ist, ist zwischen dem ringscheibenförmigen Abschnitt 2B des zweiten Gehäuseteils sowie dem ersten Gehäuseteil 2A, insbesondere zwischen dem ringscheibenförmigen Abschnitt 2B des zweiten Gehäuseteils und dem ringscheibenförmigen Abschnitt des zweiten topfförmigen Gehäuseteils 2A", ein Spalt S vorhanden, welcher erfindungsgemäß durch die erfindungsgemäße Schutzabdeckung 4 von außen abgedeckt ist.

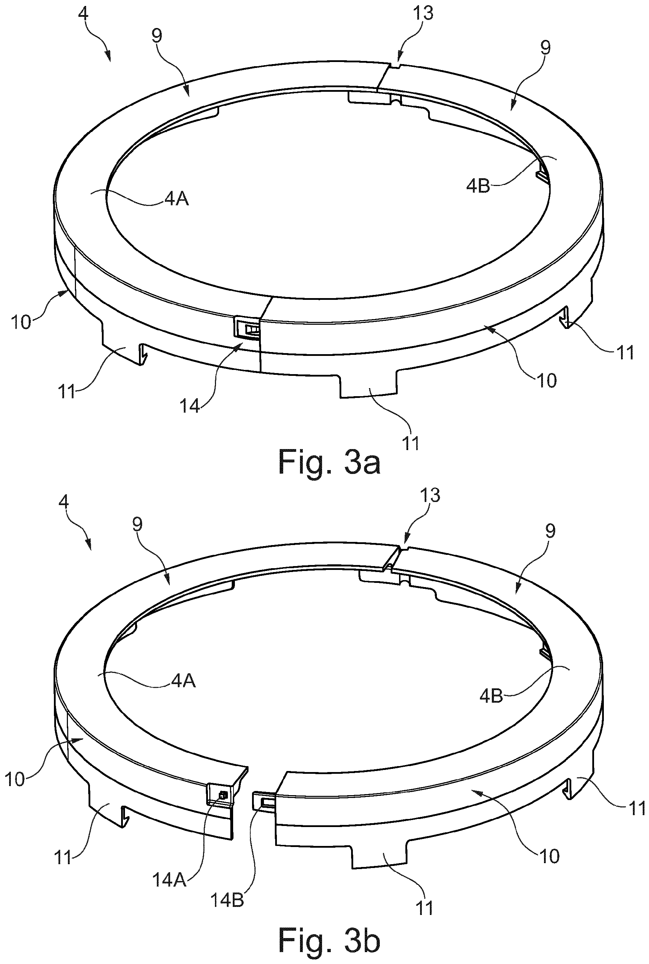

Die erfindungsgemäße Schutzabdeckung 4 weist dazu eine sich in radialer Richtung nach innen erstreckende Ringscheibe 9 sowie einen axialen Wandabschnitt 10 auf, wobei die Schutzabdeckung 4 zur Abdichtung des Spaltes S bei dieser erfindungsgemäßen Wickelfedergehäuseanordnung mit ihrer Ringscheibe 9 an dem ringscheibenförmigen Abschnitt 8 des zweiten Gehäuseteils 2B außen aufliegt. Die Ringscheibe 9 der erfindungsgemäßen Schutzabdeckung 4 ist in diesem Fall ferner vollständig umlaufend ausgebildet, bezogen auf einen funktionsgemäßen Verwendungszustand, siehe Fig. 3A, so dass bei der erfindungsgemäßen Wickelfedergehäuseanordnung der Spalt S über den gesamten Umfang abgedichtet ist. Dadurch kann sehr wirksam ein Eindringen von Fremdkörpern, wie beispielsweise Haaren oder dergleichen, in das Wickelfedergehäuse 2 verhindert werden.

Die Schutzabdeckung 4 liegt mit ihrem axialen Wandabschnitt 10 ferner außen am Wickelfedergehäuse 2 an, genauer am zylindermantelförmigen Wandabschnitt 7 des ersten Gehäuseteils 2A, insbesondere am zweiten topfförmigen Gehäuseteil 2A" sowie an der Verkleidung 5. Dadurch ist die Schutzabdeckung 4 gegenüber dem Wickelfedergehäuse 2 in radialer Richtung für eine zuverlässige Abdeckung des Spaltes 2 ausreichend festgelegt.

Zur axialen Fixierung der Schutzabdeckung 4 am Wickelfedergehäuse 2 weist die Schutzabdeckung 4 mehrere, in Umfangsrichtung gleichmäßig verteilt angeordnete Rastelemente in Form von Rasthaken 11 auf, siehe auch Fig. 3A und 3B, wobei die Rasthaken 11 jeweils hinter einen Vorsprung am zylinderförmigen Wandabschnitt 7 des ersten Gehäuseteils 2A greifen, wobei die Vorsprünge in diesem Fall jeweils durch eine Unterkante des zweiten topfförmigen Gehäuseteils 2A" gebildet werden, siehe insbesondere Fig. 2.

Um die Reibung zwischen der Schutzabdeckung 4 und dem zweiten, sich mit dem Lenkrad 1 mitdrehenden Gehäuseteil 2B sowie dem Lenkrad 1 zu verringern, weist die Oberfläche der Schutzabdeckung 4 an einer Unterseite der Ringscheibe 9, d.h. an der dem zweiten Gehäuseteil 2B zugewandten Seite, sowie an einer Oberseite, d.h. auf der dem Lenkrad 1 zugewandten Seite, eine geringe Rauigkeit auf, insbesondere einen geringen Reibwert. Des Weiteren ist die Ringscheibe 9 in diesem Bereich antistatisch ausgebildet, um eine statische Aufladung zu verhindern, wobei es in einigen Fällen vorteilhaft sein kann, die gesamte Schutzabdeckung 4 antistatisch auszubilden.

Dieses Ausführungsbeispiel einer erfindungsgemäßen Schutzabdeckung 4 ist aus zwei Halbringsegmenten 4A und 4B gebildet, siehe Fig. 3A und 3B, welche an zwei ersten, benachbarten Ringsegmentenden mittels eines Filmscharniers 13 verbunden sind, und an den anderen zwei benachbarten Ringsegmentenden mittels einer lösbaren Rastverbindung 14 miteinander verbunden werden können bzw. in einem funktionsgemäßen Verwendungszustand miteinander verbunden sind.

Dazu weist die Schutzabdeckung 4 an einem der zweiten Ringsegmentenden einen Rastvorsprung 14A auf und am anderen zweiten Ringsegmentende einen Rasthaken 14B. Die Rastelemente der Rastverbindung 14, das heißt der Rastvorsprung 14A und der Rasthaken 14B, sind dabei in vorteilhafter Weise im Bereich des axialen Wandabschnitts 10 angeordnet.

Das Filmscharnier 13, mit dem die zwei ersten, benachbarten Ringsegmentenden verbunden sind, erstreckt sich in axialer Richtung entlang der axialen Wandabschnitte 10, so dass die Ringsegmentenden nur im Bereich der axialen Wandabschnitte 10 miteinander verbunden sind, nicht jedoch im Bereich der Ringscheibe 9.

Dadurch, dass die Schutzabdeckung 4 durch zwei Halbringsegmente 4A und 4B gebildet ist, welche an einer Seite mittels eines Filmscharniers 13 miteinander verbunden sind und an der anderen Seite mittels einer Rastverbindung 14 lösbar verbunden werden können, kann die Schutzabdeckung 4 in radialer Richtung montiert werden, d.h. von außen herum um das Wickelfedergehäuse 2 in einem bereits in einem Fahrzeug eingebauten Zustand angeordnet werden, ohne dass eine Demontage des Lenkrads 1 erforderlich ist. Dies ermöglicht eine besonders einfache Nachrüstung einer erfindungsgemäßen Schutzabdeckung 4 bzw. eine besonders einfache, nachträgliche Befestigung an einem Wickelfedergehäuse 2.

Selbstverständlich ist eine Vielzahl konstruktiver Abwandlungen zu dem erläuterten Ausführungsbeispiel möglich, ohne den Inhalt der Patentansprüche zu verlassen.

## Patentansprüche

1. Schutzabdeckung (4) zur Abdichtung eines Wickelfedergehäuses (2), das ein erstes Gehäuseteil (2A) sowie wenigstens ein zweites, einen Gehäusedeckel bildendes Gehäuseteil (2B) aufweist, wobei das erste Gehäuseteil (2A) mit dem zweiten Gehäuseteil (2B) einen Aufnahmeraum für eine Wickelfeder (3) bildet, wobei die beiden Gehäuseteile (2A, 2B) gegeneinander drehbar sind und wobei das Wickelfedergehäuse (2) zwischen dem ersten Gehäuseteil (2A) und dem zweiten Gehäuseteil (2B) einen Spalt (S) aufweist,
wobei die Schutzabdeckung (4) eine sich in radialer Richtung zumindest über einen Teil eines Umfangs erstreckende Ringscheibe (9) und einen sich an einen äußeren Rand der Ringscheibe (9) anschließenden und zumindest über einen Teil des Umfangs in axialer Richtung erstreckenden Wandabschnitt (10) aufweist, wobei die Schutzabdeckung (4) derart mit dem Wickelfedergehäuse (2) verbindbar ist, dass in einem funktionsgemäßen, mit dem Wickelfedergehäuse (2) zu einer Wickelfedergehäuseanordnung verbundenen Zustand die Schutzabdeckung (4) den Spalt (S) zwischen dem ersten Gehäuseteil (2A) und dem zweiten Gehäuseteil (2B) des Wickelfedergehäuses (2) von außen abdeckt,
wobei die Schutzabdeckung (4) derart ausgebildet ist, dass in einem mit dem Wickelfedergehäuse (2) zu einer Wickelfedergehäuseanordnung verbundenen Zustand der axiale Wandabschnitt (10) der Schutzabdeckung (4) in radialer Richtung am Wickelfedergehäuse (2) anliegt, vorzugsweise am ersten Gehäuseteil (2A), insbesondere vollständig umlaufend, und dadurch in radialer Richtung gegenüber dem Wickelfedergehäuse (2) festgelegt ist,
**dadurch gekennzeichnet, dass**
die Schutzabdeckung (4) im Bereich eines zylindermantelförmigen Wandabschnittes (7) des ersten Gehäuseteils (2A) außen am Wickelfedergehäuse (2) anliegt.

2. Schutzabdeckung (4) nach Anspruch 1, **dadurch gekennzeichnet, dass** die Schutzabdeckung (4) derart mit dem Wickelfedergehäuse (2) verbindbar ist, dass in einem mit dem Wickelfedergehäuse (2) zu einer Wickelfedergehäuseanordnung verbundenen Zustand die Ringscheibe (9) der Schutzabdeckung (4) den Spalt (2) von außen abdeckt, wobei sich die Ringscheibe (9) der Schutzabdeckung (4) dazu vorzugsweise in radialer Richtung über eine Spaltbreite hinaus erstreckt und insbesondere vollständig umlaufend ausgebildet ist.

3. Schutzabdeckung (4) nach Anspruch 1 oder 2, **dadurch gekennzeichnet, dass** der axiale Wandabschnitt (10) der Schutzabdeckung (4) derart mit dem Wickelfedergehäuse (2) verbindbar ist, dass in einem mit dem Wickelfedergehäuse (2) zu einer Wickelfedergehäuseanordnung verbundenen Zustand der axiale Wandabschnitt (10) der Schutzabdeckung (4) den Spalt (S) von außen abdeckt, wobei sich der axiale Wandabschnitt (10) der Schutzabdeckung (4) dazu vorzugsweise in axialer Richtung über eine Spalthöhe hinaus erstreckt und insbesondere vollständig umlaufend ausgebildet ist.

4. Schutzabdeckung (4) nach wenigstens einem der vorgenannten Ansprüche,
**dadurch gekennzeichnet, dass** die Schutzabdeckung (4) zur axialen Festlegung gegenüber dem Wickelfedergehäuse (2) an ihrem axialen Wandabschnitt (10) in Umfangsrichtung verteilt, vorzugsweise gleichmäßig verteilt, mehrere Rastelemente (11) aufweist, insbesondere elastisch federnde Rasthaken (11), zum Herstellen einer Rastverbindung (14) mit dem Wickelfedergehäuse (2), insbesondere mit dem ersten Gehäuseteil (2A).

5. Schutzabdeckung (4) nach wenigstens einem der vorgenannten Ansprüche,
**dadurch gekennzeichnet, dass** die Schutzabdeckung (4) aus wenigstens zwei Ringsegmenten (4A, 4B) gebildet ist, vorzugsweise aus zwei Halbringsegmenten (4A, 4B).

6. Schutzabdeckung (4) nach Anspruch 5, **dadurch gekennzeichnet, dass** zwei erste, benachbarte Ringsegmentenden mittels eines Scharniers (13) miteinander verbunden sind, vorzugsweise mittels eines Filmscharniers (13), wobei insbesondere nur die axialen Wandabschnitte (10) der Ringsegmentenden mittels des Scharniers (13) verbunden sind.

7. Schutzabdeckung (4) nach Anspruch 5 oder 6, **dadurch gekennzeichnet, dass** zwei andere, benachbarte Ringsegmentenden mittels einer Rastverbindung (14) miteinander verbindbar sind oder miteinander verbunden sind.

8. Schutzabdeckung (4) nach wenigstens einem der vorgenannten Ansprüche,
**dadurch gekennzeichnet, dass** die Ringscheibe (9) der Schutzabdeckung (4) auf einer, in einem funktionsgemäßen Einbauzustand in einem Fahrzeug, dem als Rotor ausgebildeten Gehäuseteil (2B) zugewandten Seite eine Oberfläche mit einer geringen Rauigkeit aufweist, insbesondere eine Oberfläche mit einem geringen Reibwert.

9. Schutzabdeckung (4) nach wenigstens einem der vorgenannten Ansprüche,
**dadurch gekennzeichnet, dass** wenigstens die, in einem funktionsgemäßen Einbauzustand in einem Fahrzeug, dem als Rotor ausgebildeten Gehäuseteil (2B) zugewandte Seite der Ringscheibe der Schutzabdeckung (4) eine antistatische Oberfläche aufweist, wobei vorzugsweise die gesamte Schutzabdeckung (4) eine antistatische Oberfläche aufweist, und wobei insbesondere die gesamte Schutzabdeckung (4) antistatisch ausgebildet ist.

10. Wickelfedergehäuseanordnung mit einem Wickelfedergehäuse (2) und einer Schutzabdeckung (4), wobei das Wickelfedergehäuse (2) ein erstes Gehäuseteil (2A) sowie wenigstens ein zweites, einen Gehäusedeckel bildendes Gehäuseteil (2B) aufweist, wobei das erste Gehäuseteil (2A) mit dem zweiten Gehäuseteil (2B) einen Aufnahmeraum für eine Wickelfeder (3) bildet, wobei die beiden Gehäuseteile (2a, 2b) gegeneinander drehbar sind, und wobei das Wickelfedergehäuse (2) zwischen dem ersten Gehäuseteil (2A) und dem zweiten Gehäuseteil (2B) einen Spalt (S) aufweist,
**dadurch gekennzeichnet, dass** die Schutzabdeckung (4) nach einem der Ansprüche 1 bis 9 ausgebildet ist und den Spalt (S) von außen abdeckt.

11. Wickelfedergehäuseanordnung nach Anspruch 10, **dadurch gekennzeichnet, dass** das Wickelfedergehäuse (2) ein erstes, topfförmiges Gehäuseteil (2A) mit einem ringscheibenförmig ausgestalteten Boden (6) und mit einem zylindermantelförmigen Wandabschnitt (7) aufweist sowie wenigstens ein zweites, Gehäuseteil (2B), das wenigstens einen ringscheibenförmigen Abschnitt (12) aufweist, wobei sich der ringscheibenförmige Abschnitt (12) des zweiten Gehäuseteils (2B) in radialer Richtung erstreckt und in axialer Richtung beabstandet zum ringscheibenförmigen Boden (6) des ersten Gehäuseteils (2A) angeordnet ist und mit dem ersten Gehäuseteil (2A) den Aufnahmeraum für eine Wickelfeder (3) bildet und wobei sich der Spalt (S) zwischen dem ersten Gehäuseteil (2A) und dem zweiten Gehäuseteil (2B) befindet.

12. Wickelfedergehäuseanordnung nach Anspruch 10 oder 11, **dadurch gekennzeichnet, dass** die Ringscheibe (9) der Schutzabdeckung (4) den Spalt (S) im Wickelfedergehäuse (2) von außen abdeckt, wobei sich die Ringscheibe (9) der Schutzabdeckung (4) dazu vorzugsweise in radialer Richtung über eine Spaltbreite hinaus erstreckt und insbesondere vollständig umlaufend ausgebildet ist.

13. Wickelfedergehäuseanordnung nach wenigstens einem der Ansprüche 10 bis 12, **dadurch gekennzeichnet, dass** der axiale Wandabschnitt (10) der Schutzabdeckung (4) den Spalt (S) von außen abdeckt, wobei sich der axiale Wandabschnitt (10) der Schutzabdeckung (4) dazu vorzugsweise in axialer Richtung über eine Spalthöhe hinaus erstreckt und insbesondere vollständig umlaufend ausgebildet ist.

14. Wickelfedergehäuseanordnung nach wenigstens einem der Ansprüche 10 bis 13, **dadurch gekennzeichnet, dass** der axiale Wandabschnitt (10) der Schutzabdeckung (4) in radialer Richtung außen am Wickelfedergehäuse (2) anliegt, vorzugsweise am ersten Gehäuseteil (2A), insbesondere vollständig umlaufend, und dadurch in radialer Richtung gegenüber dem Wickelfedergehäuse (2) festgelegt ist.

15. Wickelfedergehäuseanordnung nach wenigstens einem der Ansprüche 10 bis 14, **dadurch gekennzeichnet, dass** die Schutzabdeckung (4) zur axialen Festlegung gegenüber dem Wickelfedergehäuse (2) mit dem Wickelfedergehäuse (2) mittels mehrerer, vorzugsweise in Umfangsrichtung gleichmäßig verteilt angeordneter Rastverbindungen verbunden ist, wobei die Schutzabdeckung (4) dazu, insbesondere an ihrem axialen Wandabschnitt (10), in Umfangsrichtung verteilt, vorzugsweise gleichmäßig verteilt, mehrere Rastelemente (11) aufweist, insbesondere elastisch federnde Rasthaken (11), und das Wickelfedergehäuse (2) vorzugsweise mehrere korrespondierend ausgebildete Rastvorsprünge, wobei diese vorzugsweise am zylindermantelförmigen Wandabschnitt (7) des ersten Gehäuseteils (2A) angeordnet sind.

16. Fahrzeug, insbesondere zweispuriges Fahrzeug, mit einer Wickelfedergehäuseanordnung mit einem Wickelfedergehäuse (2) und einer Schutzabdeckung (4), **dadurch gekennzeichnet, dass** die Wickelfedergehäuseanordnung nach einem der Ansprüche 10 bis 15 ausgebildet ist und eine Schutzabdeckung (4) nach einem der Ansprüche 1 bis 9 aufweist.

## Claims

1. Protective covering (4) for sealing a flat spiral spring housing (2) which has a first housing part (2A) and at least a second housing part (2B) which forms a housing cover, the first housing part (2A) forming, with the second housing part (2B), a receiving space for a flat spiral spring (3), the two housing parts (2A, 2B) being rotatable with respect to one another, and the flat spiral spring housing (2) having a gap (S) between the first housing part (2A) and the second housing part (2B),
wherein the protective covering (4) has an annular disc (9) which extends in the radial direction at least over part of a circumference and a wall section (10) which adjoins an outer edge of the annular disc (9) and extends at least over part of the circumference in the axial direction, it being possible for the protective covering (4) to be connected to the flat spiral spring housing (2) in such a way that, in a functional state in which it is connected to the flat spiral spring housing (2) to form a flat spiral spring housing arrangement, the protective covering (4) covers the gap (S) between the first housing part (2A) and the second housing part (2B) of the flat spiral spring housing (2) from the outside,
wherein the protective covering (4) is configured in such a way that, in a state in which it is connected to the flat spiral spring housing (2) to form a flat spiral spring housing arrangement, the axial wall section (10) of the protective covering (4) bears in the radial direction against the flat spiral spring housing (2), preferably against the first housing part (2A), in particular in a completely circumferential manner, and is fixed in the radial direction with respect to the flat spiral spring housing (2) as a result,
**characterized in that**
the protective covering (4) bears against the flat spiral spring housing (2) on the outside in the region of a cylinder shell-shaped wall section (7) of the first housing part (2A).

2. Protective covering (4) according to Claim 1,
**characterized in that** the protective covering (4) can be connected to the flat spiral spring housing (2) in such a way that, in a state in which it is connected to the flat spiral spring housing (2) to form a flat spiral spring housing arrangement, the annular disc (9) of the protective covering (4) covers the gap (2) from the outside, the annular disc (9) of the protective covering (4) to this end preferably extending in the radial direction beyond a gap width and, in particular, being of completely circumferential configuration.

3. Protective covering (4) according to Claim 1 or 2,
**characterized in that** the axial wall section (10) of the protective covering (4) can be connected to the flat spiral spring housing (2) in such a way that, in a state in which it is connected to the flat spiral spring housing (2) to form a flat spiral spring housing arrangement, the axial wall section (10) of the protective covering (4) covers the gap (S) from the outside, the axial wall section (10) of the protective covering (4) to this end preferably extending in the axial direction beyond a gap height and, in particular, being of completely circumferential configuration.

4. Protective covering (4) according to at least one of the preceding claims, **characterized in that**, for axial fixing with respect to the flat spiral spring housing (2), the protective covering (4) has a plurality of latching elements (11), in particular elastically resilient latching hooks (11), in a manner which is distributed in the circumferential direction, preferably in a uniformly distributed manner, on its axial wall section (10) in order to establish a latching connection (14) to the flat spiral spring housing (2), in particular to the first housing part (2A) .

5. Protective covering (4) according to at least one of the preceding claims, **characterized in that** the protective covering (4) is formed from at least two ring segments (4A, 4B), preferably from two half-ring segments (4A, 4B).

6. Protective covering (4) according to Claim 5,
**characterized in that** two first, adjacent ring segment ends are connected to one another by means of a hinge (13), preferably by means of an integral hinge (13), only the axial wall sections (10) of the ring segment ends being connected by means of the hinge (13), in particular.

7. Protective covering (4) according to Claim 5 or 6,
**characterized in that** two other, adjacent ring segment ends can be connected to one another or are connected to one another by means of a latching connection (14).

8. Protective covering (4) according to at least one of the preceding claims, **characterized in that** the annular disc (9) of the protective covering (4) has a surface with a low roughness, in particular a surface with a low coefficient of friction, on a side which faces the housing part (2B) which is configured as a rotor in a functional installed state in a vehicle.

9. Protective covering (4) according to at least one of the preceding claims, **characterized in that** at least that side of the annular disc of the protective covering (4) which, in a functional installed state in a vehicle, faces the housing part (2B) which is configured as a rotor has an anti-static surface, the entire protective covering (4) preferably having an anti-static surface, and, in particular, the entire protective covering (4) being of anti-static configuration.

10. Flat spiral spring housing arrangement having a flat spiral spring housing (2) and a protective covering (4), the flat spiral spring housing (2) having a first housing part (2A) and at least a second housing part (2B) which forms a housing cover, the first housing part (2A) forming, with the second housing part (2B), a receiving space for a flat spiral spring (3), the two housing parts (2a, 2b) being rotatable with respect to one another, and the flat spiral spring housing (2) having a gap (S) between the first housing part (2A) and the second housing part (2B),
**characterized in that** the protective covering (4) is configured according to one of Claims 1 to 9 and covers the gap (S) from the outside.

11. Flat spiral spring housing arrangement according to Claim 10, **characterized in that** the flat spiral spring housing (2) has a first, cup-shaped housing part (2A) with a bottom (6) of annular disc-shaped configuration and with a cylinder shell-shaped wall section (7), and at least a second housing part (2B) which has at least one annular disc-shaped section (12), the annular disc-shaped section (12) of the second housing part (2B) extending in the radial direction and being arranged spaced apart in the axial direction from the annular disc-shaped bottom (6) of the first housing part (2A), and forming, with the first housing part (2A), the receiving space for a flat spiral spring (3), and the gap (S) being situated between the first housing part (2A) and the second housing part (2B).

12. Flat spiral spring housing arrangement according to Claim 10 or 11, **characterized in that** the annular disc (9) of the protective covering (4) covers the gap (S) in the flat spiral spring housing (2) from the outside, the annular disc (9) of the protective covering (4) to this end preferably extending in the radial direction beyond a gap width and, in particular, being of completely circumferential configuration.

13. Flat spiral spring housing arrangement according to at least one of Claims 10 to 12, **characterized in that** the axial wall section (10) of the protective covering (4) covers the gap (S) from the outside, the axial wall section (10) of the protective covering (4) to this end preferably extending in the axial direction beyond a gap height and, in particular, being of completely circumferential configuration.

14. Flat spiral spring housing arrangement according to at least one of Claims 10 to 13, **characterized in that** the axial wall section (10) of the protective covering (4) bears in the radial direction on the outside against the flat spiral spring housing (2), preferably against the first housing part (2A), in particular in a completely circumferential manner, and, as a result, is fixed in the radial direction with respect to the flat spiral spring housing (2).

15. Flat spiral spring housing arrangement according to at least one of Claims 10 to 14, **characterized in that**, for axial fixing with respect to the flat spiral spring housing (2), the protective covering (4) is connected to the flat spiral spring housing (2) by means of a plurality of latching connections which are preferably arranged in a uniformly distributed manner in the circumferential direction, the protective covering (4) to this end having a plurality of latching elements (11), in particular elastically resilient latching hooks (11), in a manner which is distributed in the circumferential direction, preferably uniformly, in particular on its axial wall section (10), and the flat spiral spring housing (2) preferably having a plurality of latching projections of corresponding configuration, the said latching projections preferably being arranged on the cylinder shell-shaped wall section (7) of the first housing part (2A).

16. Vehicle, in particular double-track vehicle, having a flat spiral spring housing arrangement with a flat spiral spring housing (2) and a protective covering (4),
**characterized in that** the flat spiral spring housing arrangement is configured according to one of Claims 10 to 15 and has a protective covering (4) according to one of Claims 1 to 9.

## Revendications

1. Recouvrement de protection (4) servant à l'étanchéité d'un boîtier de ressort spiral (2) qui comprend une première partie de boîtier (2A) et au moins une deuxième partie de boîtier (2B) formant un couvercle de boîtier, dans lequel la première partie de boîtier (2A) forme avec la deuxième partie de boîtier (2B) un espace de réception pour un ressort spiral (3), dans lequel les deux parties de boîtier (2A, 2B) peuvent tourner l'une par rapport à l'autre, et dans lequel le boîtier de ressort spiral (2) présente un interstice (S) entre la première partie de boîtier (2A) et la deuxième partie de boîtier (2B),
dans lequel le recouvrement de protection (4) comprend un disque annulaire (9) s'étendant dans la direction radiale au moins sur une partie d'une périphérie et une partie de paroi (10) se raccordant à une paroi extérieure du disque annulaire (9) et s'étendant au moins sur une partie de la périphérie dans la direction axiale,
dans lequel le recouvrement de protection (4) peut être relié au boîtier de ressort spiral (2) de telle sorte que dans un état fonctionnel relié au boîtier de ressort spiral (2) pour former un ensemble de boîtier de ressort spiral, le recouvrement de protection (4) recouvre depuis l'extérieur l'interstice (S) entre la première partie de boîtier (2A) et la deuxième partie de boîtier (2B) du boîtier de ressort spiral (2),
dans lequel le recouvrement de protection (4) est réalisé de telle sorte que, dans un état relié au boîtier de ressort spiral (2) pour former un ensemble de boîtier de ressort spiral, la partie de paroi axiale (10) du recouvrement de protection (4) s'appuie contre le boîtier de ressort spiral (2) dans la direction radiale, de préférence contre la première partie de boîtier (2A), en particulier sur toute la périphérie, et est ainsi fixée par rapport au boîtier de ressort spiral (2) dans la direction radiale,
**caractérisé en ce que**
le recouvrement de protection (4) s'appuie contre l'extérieur du boîtier de ressort spiral (2) dans la région d'une partie de paroi (7) en forme d'enveloppe cylindrique de la première partie de boîtier (2A).

2. Recouvrement de protection (4) selon la revendication 1, **caractérisé en ce que** le recouvrement de protection (4) peut être relié au boîtier de ressort spiral (2) de telle sorte que, dans un état relié au boîtier de ressort spiral (2) pour former un ensemble de boîtier de ressort spiral, le disque annulaire (9) du recouvrement de protection (4) recouvre l'interstice (2) depuis l'extérieur, le disque annulaire (9) du recouvrement de protection (4) s'étendant à cet effet de préférence dans la direction radiale au-delà d'une largeur d'interstice et étant réalisé en particulier sur toute la périphérie.

3. Recouvrement de protection (4) selon la revendication 1 ou 2, **caractérisé en ce que** la partie de paroi axiale (10) du recouvrement de protection (4) peut être reliée au boîtier de ressort spiral (2) de telle sorte que, dans un état relié au boîtier de ressort spiral (2) pour former un ensemble de boîtier de ressort spiral, la partie de paroi axiale (10) du recouvrement de protection (4) recouvre l'interstice (S) depuis l'extérieur, la partie de paroi axiale (10) du recouvrement de protection (4) s'étendant à cet effet de préférence dans la direction axiale au-delà d'une hauteur d'interstice et étant réalisée en particulier sur toute la périphérie.

4. Recouvrement de protection (4) selon au moins l'une des revendications précédentes, **caractérisé en ce que** le recouvrement de protection (4) comprend, pour la fixation axiale par rapport au boîtier de ressort spiral (2), sur sa partie de paroi axiale (10) de manière répartie dans la direction périphérique, de préférence de manière répartie uniformément, plusieurs éléments d'encliquetage (11), en particulier des crochets d'encliquetage (11) souples élastiquement, pour produire une liaison par encliquetage (14) avec le boîtier de ressort spiral (2), en particulier avec la première partie de boîtier (2A).

5. Recouvrement de protection (4) selon au moins l'une des revendications précédentes, **caractérisé en ce que** le recouvrement de protection (4) est formé à partir d'au moins deux segments de bague (4A, 4B), de préférence à partir de deux segments de demi-bague (4A, 4B).

6. Recouvrement de protection (4) selon la revendication 5, **caractérisée en ce que** deux premières extrémités adjacentes de segment de bague sont reliées l'une à l'autre au moyen d'une charnière (13), de préférence au moyen d'une charnière film (13), en particulier seulement les parties de paroi axiale (10) des extrémités de segment de bague étant reliées au moyen de la charnière (13).

7. Recouvrement de protection (4) selon la revendication 5 ou 6, **caractérisé en ce que** deux autres extrémités adjacentes de segment de bague sont reliées ou peuvent être reliées l'une à l'autre au moyen d'une liaison par encliquetage (14).

8. Recouvrement de protection (4) selon au moins l'une des revendications précédentes, **caractérisé en ce que** le disque annulaire (9) du recouvrement de protection (4) comprend, sur un côté tourné vers la partie de boîtier (2B) réalisée sous forme de rotor dans un état d'installation fonctionnel dans un véhicule, une surface présentant une rugosité faible, en particulier une surface présentant un coefficient de friction faible.

9. Recouvrement de protection (4) selon au moins l'une des revendications précédentes, **caractérisé en ce qu'**au moins le côté du disque annulaire du recouvrement de protection (4) tourné vers la partie de boîtier (2B) réalisée sous forme de rotor dans un état d'installation fonctionnel dans un véhicule comprend une surface antistatique, de préférence la totalité du recouvrement de protection (4) comprenant une surface antistatique, et en particulier la totalité du recouvrement de protection (4) étant réalisée de manière antistatique.

10. Ensemble de boîtier de ressort spiral comprenant un boîtier de ressort spiral (2) et un recouvrement de protection (4), dans lequel le boîtier de ressort spiral (2) comprend une première partie de boîtier (2A) et au moins une deuxième partie de boîtier (2B) formant un couvercle de boîtier, dans lequel la première partie de boîtier (2A) forme avec la deuxième partie de boîtier (2B) un espace de réception pour un ressort spiral (3), dans lequel les deux parties de boîtier (2a, 2b) peuvent tourner l'une par rapport à l'autre, et dans lequel le boîtier de ressort spiral (2) présente un interstice (S) entre la première partie de boîtier (2A) et la deuxième partie de boîtier (2B),
**caractérisé en ce que** le recouvrement de protection (4) est réalisé selon l'une des revendications 1 à 9 et recouvre l'interstice (S) depuis l'extérieur.

11. Ensemble de boîtier de ressort spiral selon la revendication 10, **caractérisé en ce que** le boîtier de ressort spiral (2) comprend une première partie de boîtier (2A) en forme de pot dotée d'un fond (6) configuré en forme de disque annulaire et d'une partie de paroi (7) en forme d'enveloppe cylindrique ainsi qu'au moins une deuxième partie de boîtier (2B) qui comprend au moins une partie (12) en forme de disque annulaire, la partie (12) en forme de disque annulaire de la deuxième partie de boîtier (2B) s'étendant dans la direction radiale et étant disposée de manière espacée du fond (6) en forme de disque annulaire de la première partie de boîtier (2A) dans la direction axiale et formant avec la première partie de boîtier (2A) l'espace de réception pour un ressort spiral (3), et l'interstice (S) se trouvant entre la première partie de boîtier (2A) et la deuxième partie de boîtier (2B).

12. Ensemble de boîtier de ressort spiral selon la revendication 10 ou 11, **caractérisé en ce que** le disque annulaire (9) du recouvrement de protection (4) recouvre l'interstice (S) dans le boîtier de ressort spiral (2) depuis l'extérieur, le disque annulaire (9) du recouvrement de protection (4) s'étendant à cet effet de préférence dans la direction radiale au-delà d'une largeur d'interstice et étant réalisé en particulier sur toute la périphérie.

13. Ensemble de boîtier de ressort spiral selon au moins l'une des revendications 10 à 12, **caractérisé en ce que** la partie de paroi axiale (10) du recouvrement de protection (4) recouvre l'interstice (S) depuis l'extérieur, la partie de paroi axiale (10) du recouvrement de protection (4) s'étendant à cet effet de préférence dans la direction axiale au-delà d'une hauteur d'interstice et étant réalisée en particulier sur toute la périphérie.

14. Ensemble de boîtier de ressort spiral selon au moins l'une des revendications 10 à 13, **caractérisé en ce que** la partie de paroi axiale (10) du recouvrement de protection (4) s'appuie contre l'extérieur du boîtier de ressort spiral (2) dans la direction radiale, de préférence contre la première partie de boîtier (2A), en particulier sur toute la périphérie, et est ainsi fixée par rapport au boîtier de ressort spiral (2) dans la direction radiale.

15. Ensemble de boîtier de ressort spiral selon au moins l'une des revendications 10 à 14, **caractérisé en ce que** le recouvrement de protection (4) est, pour la fixation axiale par rapport au boîtier de ressort spiral (2), relié au boîtier de ressort spiral (2) au moyen de plusieurs liaisons par encliquetage disposées de préférence de manière répartie uniformément dans la direction périphérique, le recouvrement de protection (4) comprenant à cet effet, en particulier sur sa partie de paroi axiale (10), de manière répartie dans la direction périphérique, de préférence de manière répartie uniformément, plusieurs éléments d'encliquetage (11), en particulier des crochets d'encliquetage (11) souples élastiquement, et le boîtier de ressort spiral (2) comprenant de préférences plusieurs saillies d'encliquetage réalisées de manière correspondante, celles-ci étant disposées de préférence sur la partie de paroi (7) en forme d'enveloppe cylindrique de la première partie de boîtier (2A).

16. Véhicule, en particulier véhicule à deux voies, comprenant un ensemble de boîtier de ressort spiral comprenant un boîtier de ressort spiral (2) et un recouvrement de protection (4), **caractérisé en ce que** l'ensemble de boîtier de ressort spiral est réalisé selon l'une des revendications 10 à 15 et comprend un recouvrement de protection (4) selon l'une des revendications 1 à 9.
